# EUROPEAN PATENT APPLICATION

(11) **EP 1 550 888 A1**
(43) Date of publication of application: **06.07.2005**
(21) Application number: 04257942.5
(22) Date of filing: 18.12.2004
(51) Int. Cl.: G02B 6/122, G02B 6/136, G02B 6/132, G02B 6/42, G02B 6/43

(54) **Methods of forming electronic and optical components using laser ablation**

(30) Priority: 22.12.2003 US 532145 P
(71) Applicant: Rohm and Haas Electronic Materials, L.L.C., Marlborough, Massachusetts 01752 (US)
(72) Inventor: Moynihan, Matthew L., Sterling Massachusetts 01564 (US); Colangelo, Carl J., New Bedford Massachusetts 02745 (US); Shelnut, James G., Northboro Massachusetts 01532 (US); Sicard, Bruno M., Attleboro Massachusetts 02703 (US); Pugliano, Nicola, Grafton Massachusetts 01519 (US)
(74) Representative: Buckley, Guy Julian

(57) **Abstract**

Provided are methods of forming an electronic and/or optical component. The methods involve: (a) providing an electronic substrate having a polymeric layer, wherein the polymeric layer includes a polymer with units of the formula (R¹SiO_{1.5}), wherein R¹ is a substituted or unsubstituted organic group; and (b) removing selected portions of the polymeric layer by laser ablation. The invention has particular applicability in the electronics and optoelectronics industries.

## Description

### CROSS-REFERENCE TO RELATED APPLICATIONS

This application claims the benefit under 35 U.S.C. § 119(e) of U.S. Provisional Application No. 60/532,145, filed December 22, 2003, the entire contents of which are incorporated herein by reference.

### BACKGROUND OF THE INVENTION

The present invention relates generally to electronic and/or optical components. In particular, the present invention relates to methods of forming electronic and/or optical components using laser ablation techniques.

Signal transmission using pulse sequences of light is becoming increasingly important in high-speed communications. For example, optical integrated circuits (OICs) are gaining importance for high bandwidth optical interconnects. As a result, the integration of optical components such as waveguides, filters, optical interconnects, lenses, diffraction gratings, optical vias, and the like, is becoming increasingly important.

A challenge facing this technology lies in the development of an optical material having desirable properties that can be patterned using laser ablation techniques to form such optical components. International publication number WO 03/005616 discloses laser ablation patterning techniques used in connection with multi-level printed wiring boards (PWBs) designed to generate optical signals. The entire top surface of the PWB is laminated with a first polymeric optical conductive layer. A second, higher refractive index polymer having the same properties as the first layer is laminated on the entire top surface area. Using alignment targets on the edges of the PWB, the layers are channeled by laser ablation down to the underlying copper layer. An additional layer of the first layer polymer material is laminated over the top surface of the PWB, thus forming optical waveguides. Another section of the three-layered structure is channeled down to the underlying copper layer by laser ablation where a through-hole is to be located.

WO 03/005616 discloses Polyguide™ as the polymeric material. As understood, this material is an acrylate-based material. There are, however, various drawbacks associated with the use of acrylates in forming optical components. For example, acrylates are generally not suitable for use in high temperature applications, for example, in chip-to-chip applications. At temperatures approaching 200°C, most acrylate materials begin to decompose and depolymerize, giving rise to reliability problems in the form, for example, of degradation in optical performance. Thus, areas of the material in the vicinity of the laser beam may become optically and/or electrically degraded due to localized heating. Moreover, acrylates suffer from the disadvantage of being structurally and optically dissimilar to glass. Glass, being the current material of choice for optical fibers and pigtail structures, provides beneficial structural and optical properties. In order to reduce problems associated with optical loss, it is desirable to employ materials for optical components having properties more closely matching those of glass than do acrylates. In addition, the polymeric material as described must be laminated. Lamination is not a process typically used in or compatible with wafer processing for chip-to-chip applications.

There is thus a need for improved methods of forming electronic and/or optical devices which overcome or conspicuously ameliorate one or more of the problems described above.

### SUMMARY OF THE INVENTION

One aspect of the invention provides methods of forming an electronic and/or optical component. The methods involve: (a) providing an electronic substrate having a polymeric layer, wherein the polymeric layer includes a polymer with units of the formula (R¹SiO_{1.5}), wherein R¹ is a substituted or unsubstituted organic group; and (b) removing selected portions of the polymeric layer by laser ablation.

A further aspect of the invention provides methods of forming an electronic component. The methods involve: (a) providing a printed wiring board substrate having a metal layer and a polymeric layer, wherein the polymeric layer includes a polymer with units of the formula (R¹SiO_{1.5}), wherein R¹ is a substituted or unsubstituted organic group; and (b) removing selected portions of the polymeric layer by laser ablation.

Other features and advantages of the present invention will become apparent to one skilled in the art upon review of the following description, claims, and drawings appended hereto.

### BRIEF DESCRIPTION OF THE DRAWINGS

The present invention will be discussed with reference to the following drawings, in which like reference numerals denote like features, and in which:
FIG. 1(a)-(c) illustrates embedded optical waveguides at various stages of formation thereof, in accordance with one aspect of the invention;
FIG. 2(a)-(d) illustrates an optical via at various stages of formation thereof, in accordance with a further aspect of the invention;
FIG. 3(a)-(e) illustrates a blind via at various stages of formation thereof, in accordance with a further aspect of the invention;
FIG. 4(a)-(d) illustrates an optical mirror at various stages of formation thereof, in accordance with a further aspect of the invention;
FIG. 5 illustrates a further optical mirror formed accordance with a further aspect of the invention;
FIG. 6(a)-(c) illustrates concave lenses at various stages of formation thereof, in accordance with a further aspect of the invention;
FIG. 7(a)-(b) illustrates convex lenses at various stages of formation thereof, in accordance with a further aspect of the invention; and
FIG. 8(a)-(b) illustrates a diffraction grating coupler at various stages of formation thereof, in accordance with a further aspect of the invention.

### DETAILED DESCRIPTION OF THE INVENTION

Briefly stated, the present invention provides methods of forming an electronic and/or optical component. The methods involve providing an electronic substrate which includes a polymeric layer. The polymeric layer includes a polymer having units of the formula (R¹SiO_{1.5}), wherein R¹ is a substituted or unsubstituted organic group. Selected portions of the polymeric layer are removed by laser ablation.

As used herein, the terms "a" and "an" mean one or more unless otherwise specified. Also as used herein, the term "electronic component" encompasses both optoelectronic devices that include optical and electronic functionality, as well as non-optical electronic devices. The electronic component may be, for example, a printed wiring board (PWB) with or without optical functionality, an integrated circuit (IC) with or without optical functionality, and the like. The optical component may be, for example, an optical waveguide, an optical via, a turning element, a lens, a mirror, a diffraction grating, and the like. The optical components are typically used in optoelectronic devices and may be formed in situ as part of the electronic component or as a discrete part which may later be incorporated into an electronic component.

The term "electronic substrate" means a substrate useful in the manufacture of electronic components such as PWBs and ICs. Particularly suitable substrates include laminate surfaces and copper surfaces of copper clad boards, copper foils, printed wiring board inner layers and outer layers, wafers used in the manufacture of integrated circuits such as silicon, gallium arsenide, and indium phosphide wafers, glass substrates including but not limited to liquid crystal display ("LCD") glass substrates, and substrates that include dielectric coatings, cladding layers, and the like.

The substrate includes a polymeric layer on a surface thereof that can be patterned through laser ablation.

The polymeric layer includes a polymer having units of the formula (R¹SiO_{1.5}), wherein R¹ is a substituted or an unsubstituted organic group. Unless otherwise specified, amounts for components of the composition used in forming the polymeric layer are given in weight percent (wt%) based on the composition absent any solvent. As used herein, the term "polymer" includes oligomers, dimers, trimers, tetramers and the like, and encompasses homopolymers and higher order polymers, i.e., polymers formed from two or more different monomer units and heteropolymers. The term "alkyl" refers to linear, branched and cycloalkyl groups, which are substituted or unsubstituted and can include heteroatoms in or on the chain. The term "aromatic" refers to aromatic groups, which are substituted or unsubstituted and can include heterocycles.

The polymers useful in the present invention include, for example, siloxanes, silsesquioxanes, caged siloxanes, and combinations thereof. Suitable silsesquioxane polymers include, for example, POSS (Polyhedral Oligomeric Silsesquioxane)-based polymers, and those described in co-pending U.S. Application Number 10/307,904 (Attorney Docket No. DN 51203) and in published U.S. Application No. 20020172492 Al, the entire contents of which applications are incorporated herein by reference. The polymer may be present in the composition in an amount of from 1 to 99.5 wt%, for example from 60 to 98.5 wt%. Exemplary organic groups for R include substituted and unsubstituted alkyl, aryl and heterocyclic groups. The alkyl groups can be straight chain, branched or cyclic having, for example, from 1 to 20 carbon atoms, and typically have from 1 to 20 carbon atoms, such as methyl, ethyl, propyl, isopropyl, t-butyl, t-amyl, octyl, decyl, dodecyl, cetyl, stearyl, cyclohexyl, and 2-ethylhexyl. The alkyl groups can be substituted with heteroatoms in and/or on the alkyl chain, for example, or can be nonaromatic cyclic groups such as cyclopentyl, cyclohexyl, norbonyl, adamantly, piperidinyl, tetrahydrofuranyl and tetrahydrothiophenyl groups. Exemplary aryl groups include those having from 6 to 20 carbon atoms, for example, from 6 to 15 carbon atoms, such as phenyl, tolyl, benzyl, 1-naphthyl, 2-naphthyl and 2-phenanthryl, and can be substituted with heteroatoms. Heterocyclic groups can be aromatic, for example, thiophene, pyridine, pyrimidine, pyrrole, phosphole, arsole, and furane.

Typical groups for R¹ are substituted or unsubstituted methyl, ethyl, propyl, cyclopentyl, cyclohexyl, benzyl, phenyl, adamantyl, and combinations thereof.

The polymer can take the form of a homopolymer, a copolymer or higher order polymer, either random- or block-type. The polymer can include, for example, one or more additional silicon-containing unit, with the proportions for each unit ranging from 1 to 85 wt%, for example, from 15 to 80 wt% or from 25 to 60 wt%, or from 25 to 50 wt%. The additional units can, for example, be represented as siloxanes, silsesquioxanes, cage siloxanes and/or combinations thereof. For example, the polymer can further include polymerized units of the formula (R²SiO_{1.5}), wherein R² is a substituted or unsubstituted organic group as described above with respect to R¹. One of R¹ and R² can, for example, be chosen from substituted or unsubstituted alkyl groups, and the other of R¹ and R² chosen from substituted or unsubstituted aryl groups.

The polymer can be, for example, an alkyl silicon polymer such as a copolymer containing methyl silsesquioxane units and butyl silsesquioxane units; an aryl silicon polymer such as a copolymer containing phenyl silsesquioxane units and trifluoromethylphenyl-silsesquioxane units or an aralkyl silicon copolymer such as a copolymer containing methyl and phenyl silsesquioxane units.

As described above, the side chain groups of the polymer can be optionally substituted. "Substituted" means that one or more hydrogen atoms on the side chain groups is replaced by another substituent group, for example, deuterium, halogen such as fluorine, bromine, and chlorine, (C₁-C₆)alkyl, (C₁-C₆)haloalkyl, (C₁-C₁₀)alkoxy, (C₁-C₁₀)alkylcarbonyl, (C₁-C₁₀)alkoxycarbonyl, (C₁-C₁₀)alkylcarbonyloxy, alkylamine, alkylsulfur containing materials, and the like. The polymers may contain a wide range of repeating units, either random or block. The polymer units useful in the present invention may have, for example, from 5 to 150 repeating units, typically from about 10 to 35 repeating units; and the siloxane units useful in the present invention may have for example from 5 to 150 repeating units, typically from about 7 to 25 repeating units. Thus, the polymer may vary widely in molecular weight. Typically, the polymers have a weight average molecular weight (M_{w}) of from about 500 to 15,000, more typically from about 1000 to 10,000, even more typically from about 1000 to 5000. It has been found that the dissolution rate of the compositions in accordance with the invention in an aqueous developer decreases with an increase in the molecular weight M_{w} and number average molecular weight, Mₙ.

The polymers further include two or more functional end groups that allow condensation polymerization to occur. Such end groups can be, for example, hydroxy; alkoxy such as ethoxy, propoxy, isopropoxy; carboxyester, amino, amido, epoxy, imino, carboxyacid, anhydride, olefinic, acrylic, acetal, orthoester, vinyl ether, and combinations thereof. Of these, hydroxy groups are typical. The functional end content can be, for example, from about 0.5 to 35 wt% based on the polymer, for example from about 1 to 10 wt%, or from about 2 to 5 wt%.

The polymer can further, optionally include one or more siloxane units, for example, of the formula (R³₂SiO), wherein R³ is a substituted or unsubstituted alkyl or aryl group. Exemplary such siloxanes include phenyl and methyl-substituted siloxanes.

The described polymer materials can be prepared by known methods with readily available starting materials. For example, a 50:50 methyl-phenyl silicon containing copolymer can be synthesized by condensation reaction of 50 wt% methyl-triethoxy-silane and 50 wt% phenyl-triethoxy-silane.

The compositions may optionally include an active component for altering the solubility of the composition, for example, if it is desired that the layer be photoimageable. The active component typically generates an acid or base upon activation. A wide variety of active components may be used in the present invention, including, but not limited to, photoacid generators, photobase generators, thermal acid generators and thermal base generators.

The photoacid generators useful in the present invention can be any compound or compounds which generate acid upon exposure to light. Suitable photoacid generators are known and include, but are not limited to, halogenated triazines, onium salts, sulfonated esters, substituted hydroxyimides, substituted hydroxylimines, azides, naphthoquinones such as diazonaphthoquinones, diazo compounds, and combinations thereof.

Photobase generators useful in the present invention can be any compound or compounds which liberate base upon exposure to light. Suitable photobase generators include, but are not limited to, benzyl carbamates, benzoin carbamates, O-carbamoylhydroxyamines, O-carbamoyloximes, aromatic sulfonamides, alpha-lactams, N-(2-allylethenyl)amides, arylazide compounds, N-arylformamides, 4-(ortho-nitrophenyl)dihydropyridines, and combinations thereof.

Thermal acid generators useful in the present invention can be any compound or compounds which generate an acid on heat activation. The heat can be supplied by indirect methods such as convection heating or by direct heating methods such as laser heating techniques.

Suitable thermal acid generators are known and include, but are not limited to, halogenated triazines, ammonium salts of acids, onium salts, sulfonated esters, substituted hydroxyimides, substituted hydroxylimines, azides, naphthoquinones such as diazonaphthoquinones, diazo compounds, and combinations thereof.

The amount of the component for altering the solubility useful in the present invention, in the case of a negative working material, is any amount sufficient to catalyze coupling of the silicon-containing polymer upon exposure to actinic radiation or heat to render the coupled portion insoluble in an aqueous developer. The active component, when used, is typically present in the composition in an amount of from 0.1 to 25 wt%, for example from 0.1 to 12 wt%.

Other additives may optionally be present in the compositions including, but not limited to, surface leveling agents, wetting agents, antifoam agents, adhesion promoters, thixotropic agents, and the like. Such additives are well known in the art for coating compositions. The use of surface leveling agents, for example silicone-base oils such as SILWET L-7604 silicone-base oil available from Dow Chemical Company, in the compositions can be used. It will be appreciated that more than one additive may be combined in the compositions of the present invention. For example, a wetting agent may be combined with a thixotropic agent. Such optional additives are commercially available from a variety of sources. The amounts of such optional additives to be used in the present compositions will depend on the particular additive and desired effect, and are within the ability of those skilled in the art. Such other additives are typically present in the composition in an amount of less than 5 wt%, for example less than 2.5 wt%.

The compositions can optionally contain one or more organic cross-linking agents. Cross-linking agents include, for example, materials which link up components of the composition in a three-dimensional manner. Aromatic or aliphatic cross-linking agents that react with the silicon-containing polymer are suitable for use in the present invention. Such organic cross-linking agents will cure to form a polymerized network with the silicon-containing polymer, and reduce solubility in a developer solution. Such organic cross-linking agents may be monomers or polymers. It will be appreciated by those skilled in the art that combinations of cross-linking agents may be used successfully in the present invention. Suitable organic cross-linking agents useful in the present invention include, but are not limited to: amine containing compounds, epoxy containing materials, compounds containing at least two vinyl ether groups, allyl substituted aromatic compounds, and combinations thereof.

Typical cross-linking agents include amine containing compounds and epoxy containing materials. The amine containing compounds useful as cross-linking agents in the present invention include, but are not limited to: melamine monomers, melamine polymers, alkylolmethyl melamines, benzoguanamine resins, benzoguanamine-formaldehyde resins, urea-formaldehyde resins, glycoluril-formaldehyde resins, and combinations thereof. It will be appreciated by those skilled in the art that suitable organic cross-linker concentrations will vary with factors such as cross-linker reactivity and specific application of the composition. When used, the cross-linking agent(s) is typically present in the composition in an amount of from 0.1 to 50 wt%, for example, from 0.5 to -25 wt% or from 1 to 20 wt%.

The compositions can optionally contain one or more solvents. Such solvents aid in formulating the present compositions and in coating the present compositions on a substrate. A wide variety of solvents may be used. Suitable solvents include, but are not limited to, glycol ethers, such as ethylene glycol monomethyl ether, propylene glycol monomethyl ether, dipropylene glycol monomethyl ether; esters such as methyl cellosolve acetate, ethyl cellosolve acetate, propylene glycol monomethyl ether acetate, dipropylene.glycol monomethyl ether acetate, dibasic esters, carbonates such as propylene carbonate, γ-butyrolactone, esters such as ethyl lactate, n-amyl acetate and n-butyl acetate, alcohols such as n-propanol, iso-propanol, ketones such as cyclohexanone, methyl isobutyl ketone, diisobutyl ketone and 2-heptanone, lactones such as γ-butyrolactone and γ-caprolactone, ethers such as diphenyl ether and anisole, hydrocarbons such as mesitylene, toluene and xylene, and heterocyclic compounds such as N-methyl-2-pyrrolidone, N,N'-dimethylpropyleneurea, or mixtures thereof.

The compositions can be prepared by combining, in admixture, the silicon-containing polymer and other optional components in any order.

The polymeric layer can be formed on the substrate surface from the compositions described above by various techniques including, but not limited to, screen printing, curtain coating, roller coating, slot coating, spin coating, flood coating, electrostatic spray, spray coating, or dip coating. When the composition is spray coated, a heated spray gun may optionally be used. The viscosity of the composition may be adjusted to meet the requirements for each method of application by viscosity modifiers, thixotropic agents, fillers and the like. The thickness of the layer(s) will depend on the particular application. However, typical thicknesses in the dried state are from 1 to 100 µm, for example, from about 10 to 50 µm.

The coated substrate is typically then dried to substantially remove the solvent from the coating. The drying can be conducted, for example, in an oven such as an infrared oven, a convection oven, a convection/conduction oven, a vacuum oven, or on a hot plate. Such drying may take place at various temperatures and times, depending upon the particular solvent chosen and the drying technique. Suitable temperatures are any that are sufficient to substantially remove any solvent present. Typically, the drying may be at any temperature from room temperature (25° C) to 170°C and at a time of from 5 seconds to 120 minutes. When using an oven, typical times are from 10 to 120 minutes and from 10 seconds to 10 minutes for a hot plate.

Selected, predefined portions of the polymeric layer are removed by laser ablation. The laser ablation system includes a conventional laser light source, for example, an excimer or YAG laser that produces a focused collimated beam. The laser ablation system may further include a focusing lens, a mask, and optionally other optical elements, for example, mirrors and additional lenses. The relative position of the focal point of the beam in the polymeric material as well as the angle of incidence of the beam with respect to the substrate can be selected and varied during the ablation step such that a predefined volume of the material may be ablated. This is typically accomplished by holding the laser stationary while moving the substrate on an automated stage, but may also be accomplished, for example, by holding the substrate stationary while moving the laser, or a combination thereof.

The laser beam is typically in pulsed form, with the pulse duration and fluence being selected based on the particular polymeric material so as to ablate portions of the polymeric material at a desired rate. These values will vary widely depending, for example, on the material and laser system. The pulses typically have a duration of from 1 femtosecond to 100 nanoseconds. for example, from 5 to 30 nanoseconds. The fluence of the laser beam is typically from 0.001 mJ/cm² to 10 J/cm², for example, from 0.1 to 5 J/cm². The material at a given location receives one or more pulse of the laser beam, determined by the amount of the material to be removed. The laser ablation rate will depend, for example, on the particular polymeric material, the fluence and pulse duration. Typically, the laser ablation rate is from 1 to 100 nm/pulse. The surface on which the polymeric layer is disposed should have a low ablation rate relative to the polymeric layer if it desired to stop ablation at that surface. Various wavelengths for the output from the laser can be used, for example, one or more of 193 nm, 248 nm, 355 nm, and 10,200 nm.

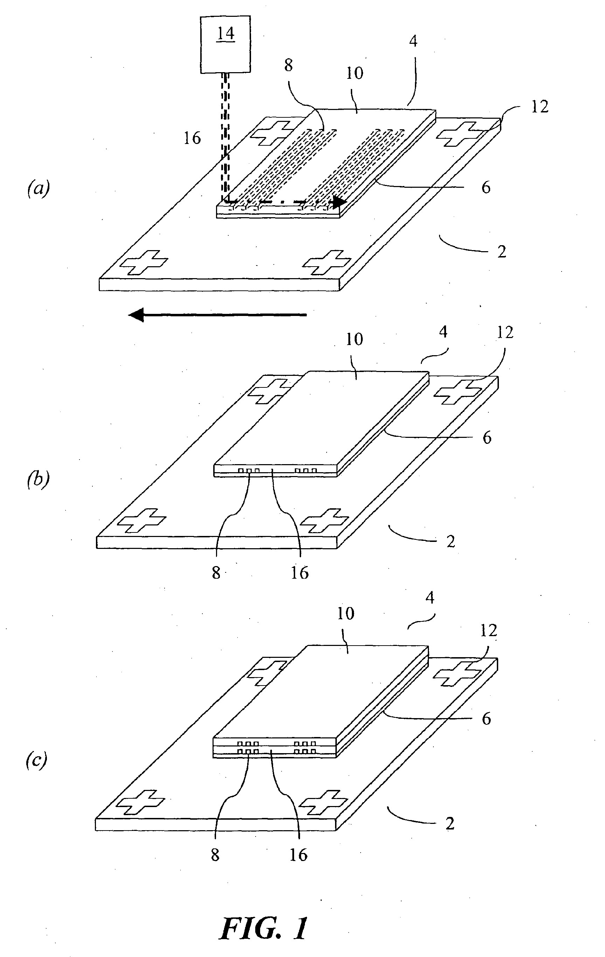

The invention will now be described with reference to the drawings, which illustrate exemplary aspects thereof. FIG. 1 illustrates an exemplary embedded optical waveguide that can be formed in part by the laser ablation techniques of the present invention. As shown in FIG. 1(a), an electronic substrate 2 is provided that has an embedded waveguide structure 4 formed on a surface thereof. The electronic substrate 2 can be any of the aforementioned electronic substrates, and is typically a PWB substrate. The embedded waveguide 4 is formed from a plurality of layers of the polymeric composition described above. The layers include a first clad layer 6, a core layer formed on the first clad layer that has been subsequently patterned into core structures 8, and a second clad layer 10 formed over the first clad layer and core structures. The embedded waveguide may include one or more (as illustrated) core structures. One or more of the first clad 6, core, second clad 10 layers making up the embedded waveguide 4 may be photoimageable, and the materials may be independently selected, with the understanding that the refractive index of the final core structure should be greater than that of the cladding. The thickness of these layers can vary widely, with a thickness of from 5 to 500 µm, for example, from 8 to 50 µm being typical. The core structures 8 may be patterned, for example, using standard photolithography and etching techniques or by photolithographic exposure and development in the case of a photoimageable material. One may further laser ablate in the same manner a plurality of embedded waveguide structures 4 in a stacked arrangement, as shown in FIG. 1(c).

The substrate 2 further may include a plurality of alignment fiducials 12 formed in or on a surface thereof. The alignment fiducials 12 may be used for alignment of subsequent features and/or for alignment of the laser 14 to the substrate 2. The alignment fiducials 12 may be formed by patterning a layer on the surface of the substrate 2, for example, using standard photolithographic and etching techniques. The material for this layer may be any which the laser system is able to recognize for alignment purposes.

Once the laser 14 and substrate 2 have been brought into alignment with each other, the laser 14 is moved relative to the substrate 2 such that the laser beam 16 follows a path across the embedded waveguide structure 4 as shown by the dashed arrow. This path typically involves a series of incremental movements, with a number of laser beam pulses being used at each stop to remove material from the face of the embedded waveguide structure 4. In this way, the laser 4 removes a slice of the embedded waveguide structure 4 to leave an optically smooth end face 16, as shown in FIG. 1(b). As a result of this structure, the embedded waveguide can be connected to optical fibers with lower optical and insertion losses. In the case of a plurality of embedded waveguide structures in a stacked arrangement, the ablation process for the stack can advantageously be performed at one time.

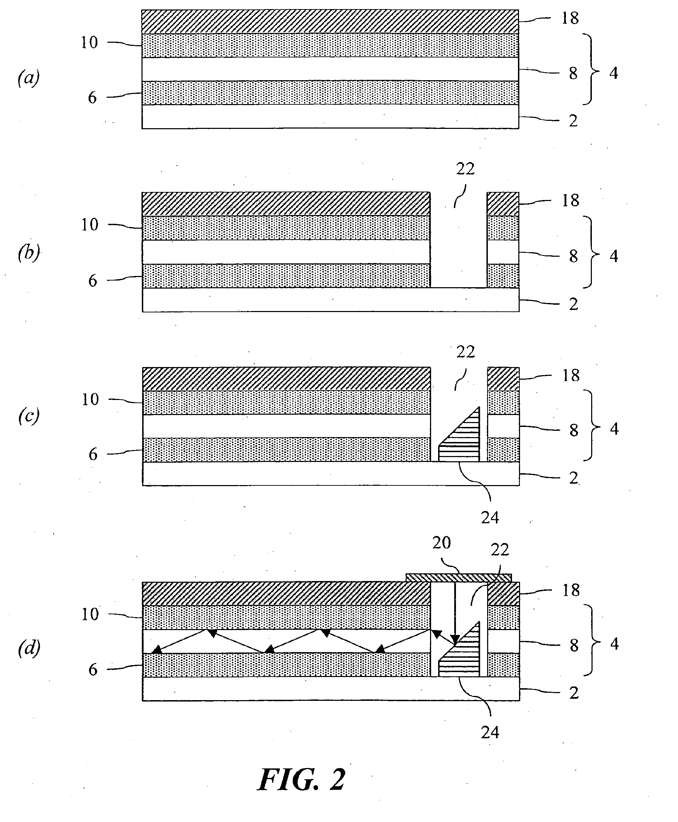

FIG. 2(a)-(d) illustrates a method of forming an optical via structure, in accordance with a further aspect of the invention. As shown in FIG. 2(a), an electronic substrate 2 is provided which may include one or more layers on a surface thereof. An embedded waveguide structure 4 which includes a first core layer 6, one or more core structures 8, and a second core layer 10, is formed over the substrate 2 as described above with reference to FIG. 1. One or more additional layers 18 may be formed over the embedded waveguide structure 4, for example, with an upper layer including a metallization structure for electrically connecting an optoelectronic device 20. A via 22 is next formed through layer(s) 18 by laser ablation or wet etching, and through embedded waveguide structure 4 by laser ablation, as shown in FIG. 2(b), thus forming optical via 22. The same laser ablation process may be used to form the via in layers 18 and the embedded waveguide 4. The via 22 is typically circular in cross-section, although other geometries are possible. The diameter of the optical via 22 is typically from 25 to 1000 µm, for example, from 75 to 500 µm.

The optical via 22 allows an optical signal to pass between the embedded waveguide 4 and another element, for example, a photodetector such as a photodiode, a light source such as a laser emitting device, e.g., a VCSEL chip, or a light propagating element such as an optical fiber. To allow the light to pass between the embedded waveguide 4 and the other element, a turning element such as a mirror 24 can be disposed in the optical via, as shown in FIG. 2(c). The mirror 24 can be a discrete component placed in the optical via 22 or can be formed in situ as described below. Optionally, the optical via 22 can be filled with a polymeric material having a refractive index matching that of the core. The exemplary embodiment uses no such fill. FIG. 2(d) illustrates the situation in which a laser emitting device 20 is bonded to layer 18 over the optical via 22. As shown by the arrows, light is transmitted by the laser emitting device 20 down through the optical via 22. The light is reflected off a surface of the mirror 24, and passes through the core structure 8 of the embedded waveguide 4. An opposite light path can be used together with a light receiving device such as a photodetector in place of the laser emitting device.

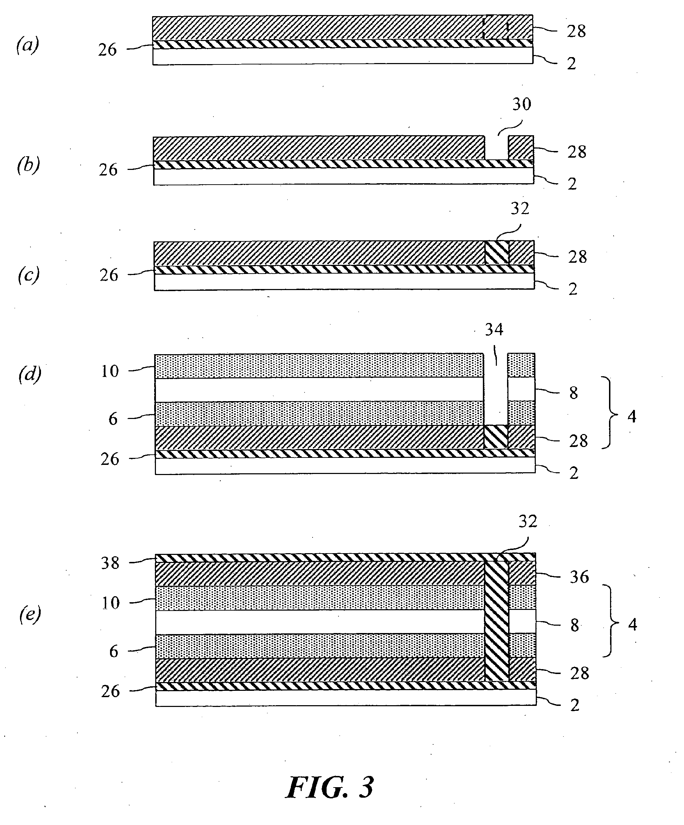

FIG. 3(a)-(e) illustrates an exemplary blind via at various stages of formation thereof. Blind vias are typically used in PWB manufacture for electrically connecting two metallization layers spaced apart from each other. FIG. 3(a) illustrates a first metal layer 26 formed on an electronic substrate 2. Typical materials for the metal layer 26 include, for example, copper and copper alloys. One or more additional layers 28 are formed over the metal layer 26. Material is removed from layer(s) 28 at locations where the blind via is to be formed, as marked by the dashed lines. This exposes a portion of the upper surface of the metal layer 26, forming a portion of the blind via structure 30, as shown in FIG. 3(b). This material from layer(s) 28 may be removed using known techniques, for example, dry etching or laser ablation. As illustrate din FIG. 3(c), the blind via portion is filled with a metal, for example, copper or a copper alloy using known techniques, such as electrolytic plating, to form metal post 32.

As shown in FIG. 3(d), one or more polymeric layers as described above are formed over the first metal layer 26 and optional layer(s) 28. In the illustrated embodiment, the polymeric layers form an embedded waveguide 4 as described above, which includes a first clad layer 6, core structures 8 formed from a core layer, and a second clad layer 10. The one or more polymeric layers may additionally or alternatively include a non-optical, dielectric layer. A via 34 is next formed through the polymeric layer(s) in line with the metal post 32 by laser ablation, and the via is filled with a metal, thus building up metal post 32. As shown in FIG. 3(e), one or more additional layers 36 may optionally be formed over the polymeric layer(s), and a via formed and filled with a metal, as described above with reference to FIG. 3(b). A second metal layer 38 is formed over the polymeric layer(s) and the optional layers 36. The blind via with metal post 32 thus provides electrical contact between the first and second metal layers 30 and 38.

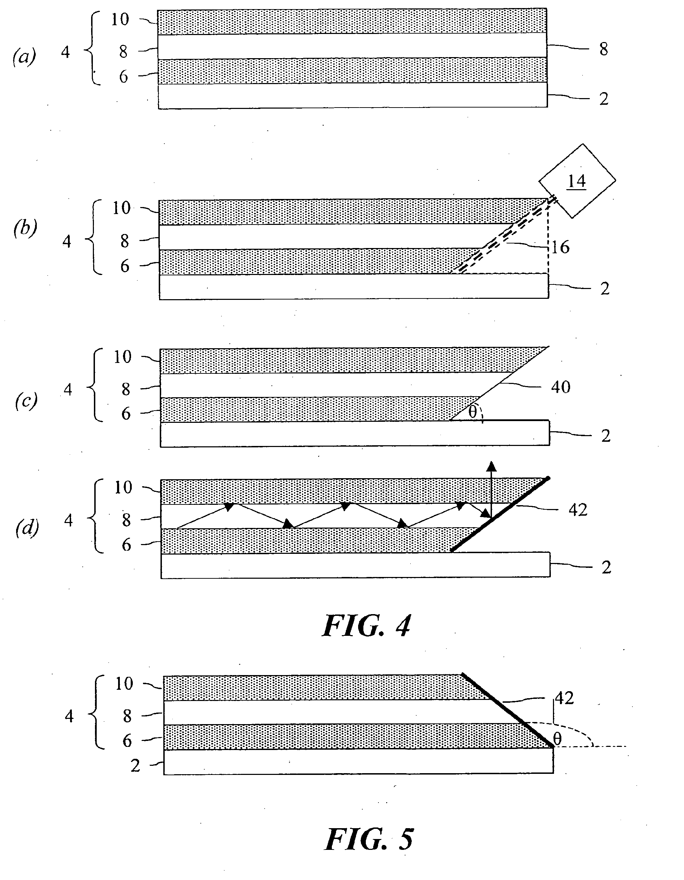

FIG. 4(a)-(d) illustrates an optical mirror at various stages of formation thereof, in accordance with a further aspect of the invention. One or more layers of the polymeric material are formed on a substrate 2, as shown in FIG. 4(a). In this exemplified embodiment, the polymeric layers form an embedded waveguide 4, as described above. As shown in FIG. 4(b), a portion of the polymeric material is removed by laser ablation from the embedded waveguide 4 so as to form an angled endface 40, as shown in FIG. 4(c). For the illustrated embodiment, the angle θ between the endface and substrate surface is selected such that the final structure will reflect light passing through the embedded waveguide to a substantially vertical plane in an upward direction, or vice versa. This angle θ is typically about 45°. A reflective layer 42 formed, for example, from a metal such as aluminum, gold, copper, silver, or other reflective material, is next formed on the endface 40 of the embedded waveguide 4, as shown in FIG. 4(d). Reflective layer 42 can be formed by various techniques, for example, sputtering, evaporation, electroless plating and/or electrolytic plating. The reflective layer 42 typically has a thickness of from 0.05 to 1 µm. The mirror can thus be used as a turning element to reflect the light from the embedded waveguide 4 as shown by the arrows, or to reflect light into the embedded waveguide from a light source above the mirror.

FIG. 5 illustrates an optical mirror formed accordance with a further aspect of the invention. The discussion above with respect to FIG. 4(a)-(d) is generally applicable to this aspect of the invention. This mirror, however, is formed such that the portion of the embedded waveguide 4 removed by laser ablation forms an angled endface 40 having an angle θ between the endface and substrate surface such that the final structure will reflect light passing through the embedded waveguide to a substantially vertical plane in a downward direction, or vice versa. This angle θ is typically about 135°.

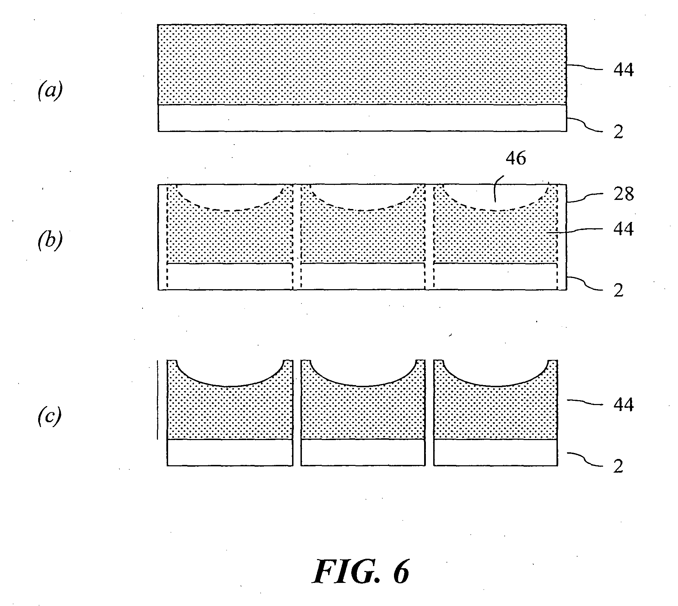

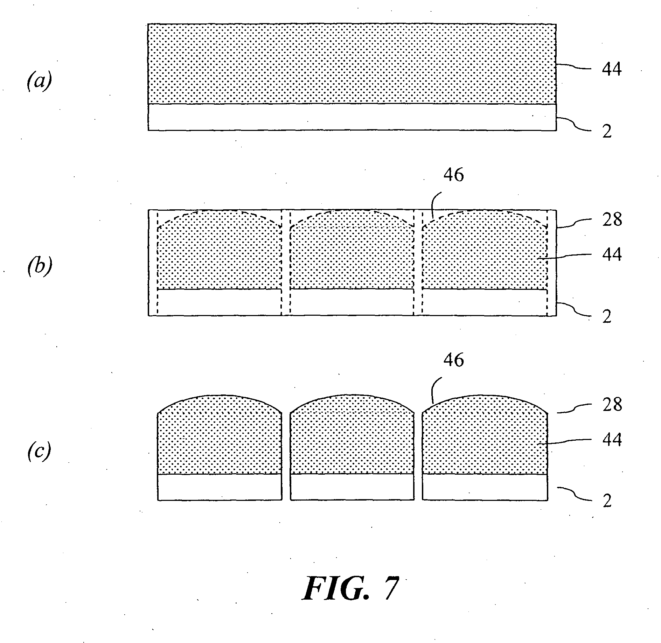

FIG. 6(a)-(c) illustrates concave lenses at various stages of formation thereof, in accordance with a further aspect of the invention. The lenses can be formed by coating a layer 44 of the polymeric composition over an electronic substrate 2. Portions 46 in an upper surface of the polymeric surface are removed by laser ablation, with the extent of ablation being controlled across the surface to produce a concave surface. In the case in which a plurality of mirrors are formed on the substrate surface, the mirrors can be separated by laser ablating areas around each of the mirrors. The mirrors can be formed in situ on the electronic substrate in a position at which it is to be used. Alternatively, this method can be used to form discrete lens components which can be used in optical or optoelectronic devices. In a similar manner, a concave lens can be formed as shown in FIG. 7(a)-(b) by removing portions 46 of the polymeric film to leave a concave surface in the polymeric layer 44.

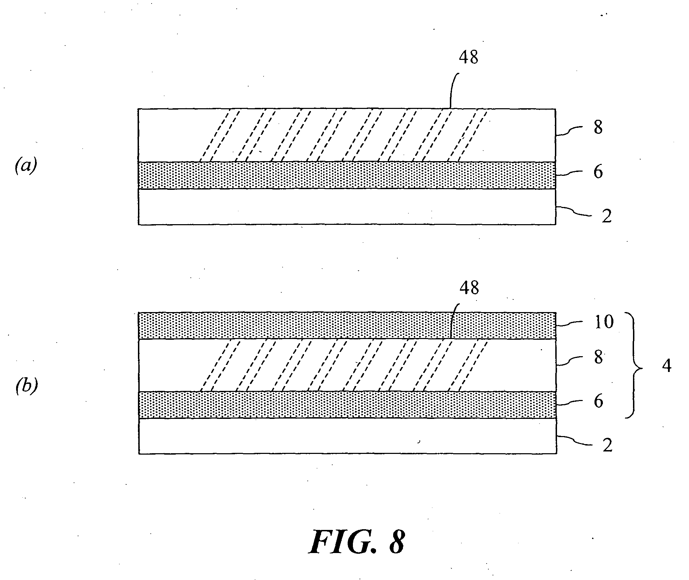

FIG. 8(a)-(b) illustrates a diffraction grating coupler at various stages of formation thereof, in accordance with a further aspect of the invention. The exemplified diffraction grating can be formed along a partial length of one or more embedded waveguides 4. A first clad layer 6 and a core layer 8 of the polymeric composition may be provided over an electronic substrate 2 as described above. Before or after forming the core structures, slots 48 are ablated into the core 8 at a predetermined pitch and angle, which determine the λ and coupling efficiency of the diffractive grating coupler. The core layer is patterned into core structures if not already done, and a second clad layer is formed over the first clad layer 6 and the core structures.

Other laser-ablated structures formed in the polymeric materials of the invention are also envisioned, and the exemplified embodiments are not to be taken as limitative. For example, laser ablation of a horizontal opening or a vertical opening or trench in the polymeric material is envisioned for purposes of receiving an optical connector, for example, to connect an optical fiber to one or more embedded waveguides.

While the invention has been described in detail with reference to specific embodiments thereof, it will be apparent to one skilled in the art that various changes and modifications can be made, and equivalents employed, without departing from the scope of the claims.

## Claims

1. A method of forming an electronic and/or optical component, comprising:
(a) providing an electronic substrate comprising a polymeric layer, wherein the polymeric layer comprises a polymer comprising units of the formula (R¹SiO_{1.5}), wherein R¹ is a substituted or unsubstituted organic group; and
(b) removing selected portions of the polymeric layer by laser ablation.

2. The method of claim 1, wherein the laser ablated polymeric layer of (b) forms at least part of an optical component.

3. The method of claim 2, wherein the optical component comprises a plurality of optical waveguides, wherein (b) comprises polishing an end face of the optical waveguides by the laser ablation.

4. The method of claim 3, wherein the optical waveguides are embedded optical waveguides in a stacked arrangement.

5. The method of claim 2, wherein the optical component is an optical via formed through the layer.

6. The method of claim 2, wherein the optical component is one or more of a lens, a mirror, or a diffraction grating.

7. The method of claim 1, wherein the laser ablated polymeric layer of (b) forms an interlayer dielectric.

8. The method of claim 1, wherein the electronic substrate is a printed wiring board substrate further comprising a metal layer and a plurality of waveguide core structures on a surface thereof, wherein the laser ablation is conducted after aligning the laser to the waveguide core structures as alignment fiducials.

9. The method of claim 1, wherein the electronic substrate is a printed wiring board substrate further comprising a metal layer, wherein the laser ablation forms a trench in the polymeric layer for receiving an optical connector.

10. The method of claim 1, wherein the electronic substrate is a printed wiring board substrate further comprising a metal layer, wherein the laser ablation forms a via in the polymeric layer, and further comprising filling the via with copper or an alloy thereof.
